# EUROPEAN PATENT SPECIFICATION

(11) **EP 3 832 586 B1**
(45) Date of publication and mention of the grant of the patent: **17.06.2026**
(21) Application number: 19844086.9
(22) Date of filing: 31.07.2019
(51) Int. Cl.: G06Q 50/10, G06Q 50/26, H01M 10/44, H01M 10/48, H02J 7/00

(54) **SERVER DEVICE, SHARED BATTERY UTILIZATION SERVICE SYSTEM, METHOD, COMPUTER PROGRAM AND RECORDING MEDIUM**
SERVERVORRICHTUNG, GEMEINSAMES BATTERIENUTZUNGSDIENSTSYSTEM, VERFAHREN, COMPUTERPROGRAMM UND AUFZEICHNUNGSMEDIUM
DISPOSITIF SERVEUR, SYSTÈME DE SERVICE D'UTILISATION DE BATTERIE PARTAGÉE, PROCÉDÉ, PROGRAMME INFORMATIQUE ET SUPPORT D'ENREGISTREMENT

(30) Priority: 31.07.2018 JP 2018143638
(43) Date of publication of application: 09.06.2021
(73) Proprietor: HONDA MOTOR CO., LTD., Tokyo 105-8404 (JP)
(72) Inventor: KAWAMURA Masayuki, Wako-shi, Saitama 351-0193 (JP); ENDO Hirotaka, Wako-shi, Saitama 351-0193 (JP)
(74) Representative: Beder, Jens
(86) International application number: PCT/JP2019/030009
(87) International publication number: WO 2020/027196

(56) References cited:
- EP-A1- 3 249 774
- EP-A2- 0 877 342
- EP-A2- 2 737 600
- EP-B1- 0 877 342
- EP-B1- 2 737 600
- EP-B1- 3 249 774
- WO-A1-2017/222015
- JP-A- 2010 081 722
- JP-A- 2012 059 197
- JP-A- 2014 527 689
- JP-A- 2018 019 483

## Description

### [Technical Field]

The present invention relates to a server device, a shared battery utilization service system, a method, a computer program and a recording medium.

Priority is claimed on Japanese Patent Application No. 2018-143638, filed July 31, 2018.

### [Background Art]

A sharing service in which a battery (a cell) that is a driving source of a moving body such as an electrically driven vehicle or the like is provided as a detachable type and shared by a plurality of users is known. In the service, a charging station configured to perform storage and charging of one or more detachable batteries is installed, and a system configured to perform billing to a user of the charging station is constructed.

In Patent Literature 1, a collection/charging/distribution device (a battery exchange station) configured to collect, charge and distribute portable electric energy storage devices when electric power is consumed using the portable electric energy storage devices (detachable batteries) is disclosed. Further, in the technology disclosed in Patent Literature 1, the collection/charging/distribution device has a plurality of containers configured to detachably accommodate portable electric energy storage devices to enable collection, charge and distribution thereof.

In addition, in Patent Literature 2, as another example of a moving body capable of detachably loading a battery into a moving body main body, a portable charge feeding device having a battery and a charge feeding unit in which an accommodating chamber configured to accommodate the battery is formed is disclosed.

EP 2 737 600 A2 is an example of redistributing power storage devices such as batteries, between the collection, charging, and distribution machines.

EP 3 249 774 A1 is related to battery selection device, battery selection method, program and recording medium.

EP 0 877 342 A2 is another example of a battery rental system and apparatus.

[Patent Literature 1]
   Published Japanese Translation No. 2014-527689 of the PCT International Publication
[Patent Literature 2]
   Japanese Unexamined Patent Application, First Publication No. 2019-068552

### [Summary of Invention]

### [Technical Problem]

However, the electrification of a moving body such as a vehicle or the like originates from environmental problems such as carbon dioxide (CO₂) reduction or the like, and CO₂ reduction (reduction in amount of power consumed due to improvement in power consumption rate) is required in not only electrification of mobility but also a usage environment of the moving body such as an electric vehicle (EV; an electric automobile) or the like of a user.

An aspect of the present invention is directed to providing a server device, a shared battery utilization service system, a method, a computer program and a recording medium that are capable of contributing to reduction in carbon dioxide under a usage environment of a moving body such as an EV or the like of a user.

### [Solution to Problem]

(1) A server device according to an aspect of the present invention is a server device as defined in claim 1.
(2) the server device according to the aspect of the present invention includes a storage configured to associate battery identification information that is information that enables identification of the battery with either one of the user or user identification information that is information that enables identification of the user and stores the associated information as corresponding information during the rental period of the battery, and the calculation part may identify the user of the battery on the basis of the battery identification information and the corresponding information.
(3) in the server device according to the aspect of the present invention, the calculation part calculates a privilege provided to the user on the basis of the improvement result in the power consumption rate.
(4) A shared battery utilization service system according to an aspect of the present invention is a shared battery utilization service system as defined in claim 3.
(5) In addition, the shared battery utilization service system according to the aspect of the present invention may further include an information terminal used by the user, the server device may transmit the improvement result in the power consumption rate to at least one of the charger configured to charge the battery and the information terminal, and the charger or the information terminal may display the improvement result in the power consumption rate.
(6) A method of providing a service in which a battery, which is detachably mounted on a moving body that is movable using electric power, is shared by a plurality of users according to an aspect of the present invention is defined in claim 5
(7) A computer program according to an aspect of the present invention is a computer program as defined in claim 6.
(8) A recording medium according to an aspect of the present invention is a computer-readable recording medium as defined in claim 7.

### [Advantageous Effects of Invention]

According to the aspects of the above-mentioned (1), (4), (6), (7) and (8), since the result which is an improvement in the power consumption rate can be calculated, it is possible to improve motivation of a user to improve a power consumption rate. Accordingly, according to the aspects of the above-mentioned (1), (4), (6), (7) and (8), it is possible to contribute to reduction in carbon dioxide (reduction in power consumption due to improvement in power consumption rate) even in a usage environment of a moving body such as an EV or the like of a user.

According to the aspect of the above-mentioned (1), (6) and (7), it is possible to accurately calculate the power consumption rate for each user by calculating the power consumption rate on the basis of the amount of the electric power used and the traveling distance of the moving body during the rental period.Since the information related to the power consumption rate includes the user identification information that is information that enables identification of the user of the battery, it is possible to identify the user from the acquired information and calculate the power consumption rate for each user.

According to the aspect of the above-mentioned (2), in the rental period of the battery, the battery identification information that is the information that enables identification of the battery and the user or the user identification information that is the information that enables identification of the user are associated with each other and is stored as corresponding information. Accordingly, according to the aspect of the above-mentioned (3), it is possible to identify the user from the acquired information and the stored information and calculate the power consumption rate for each user.

According to the aspect of the above-mentioned (3), since a return amount (a privilege) is provided to the user on the basis of the power consumption rate, it is possible to improve motivation of the user to improve the power consumption rate. Accordingly, according to the aspect of the above-mentioned (3), it is possible to contribute to reduction in carbon dioxide (reduction in power consumption due to improvement in power consumption rate) even in a usage environment of the moving body such as an EV or the like of the user.

According to the aspect of the above-mentioned (5), it is possible to display the return amount (a privilege) on at least one of the charging station (the charger) and the information terminal.

### [Brief Description of Drawings]

Fig. 1 is a view showing the entire configuration of an electric power supply system according to a first embodiment.
Fig.2 is a view showing transfer of a relationship between a detachable battery and a user ID in the first embodiment.
Fig.3 is a view showing a relationship between the detachable battery and the user ID in the first embodiment.
Fig.4 is a view showing a configuration example of the detachable battery according to the first embodiment.
Fig.5 is a view showing a configuration example of a charging station according to the first embodiment.
Fig. 6 is a view showing a configuration example of a management server according to the first embodiment.
Fig. 7 is a view showing an example of a power consumption rate, improvement results of a power consumption rate, and a provided point of each user according to the first embodiment.
Fig. 8 is a view showing an example of provided points according to the first embodiment.
Fig. 9 is a view showing an example of return of points based on electricity bill reduction according to the first embodiment.
Fig. 10 is a flowchart of processing performed by a shared battery utilization service system according to the first embodiment.
Fig. 11 is a view showing an image example displayed on a display unit of a portable terminal according to the first embodiment.
Fig. 12 is a view showing the entire configuration of a shared battery utilization service system of a second embodiment.
Fig. 13 is a view showing a configuration example of a motorcycle according to the second embodiment.

### [Description of Embodiments]

Hereinafter, embodiments of the present invention will be described with reference to the accompanying drawings. Further, in the drawings used in the following description, the scales of members are appropriately changed in order to make the respective members have recognizable sizes.

### <First embodiment>

### [Entire configuration]

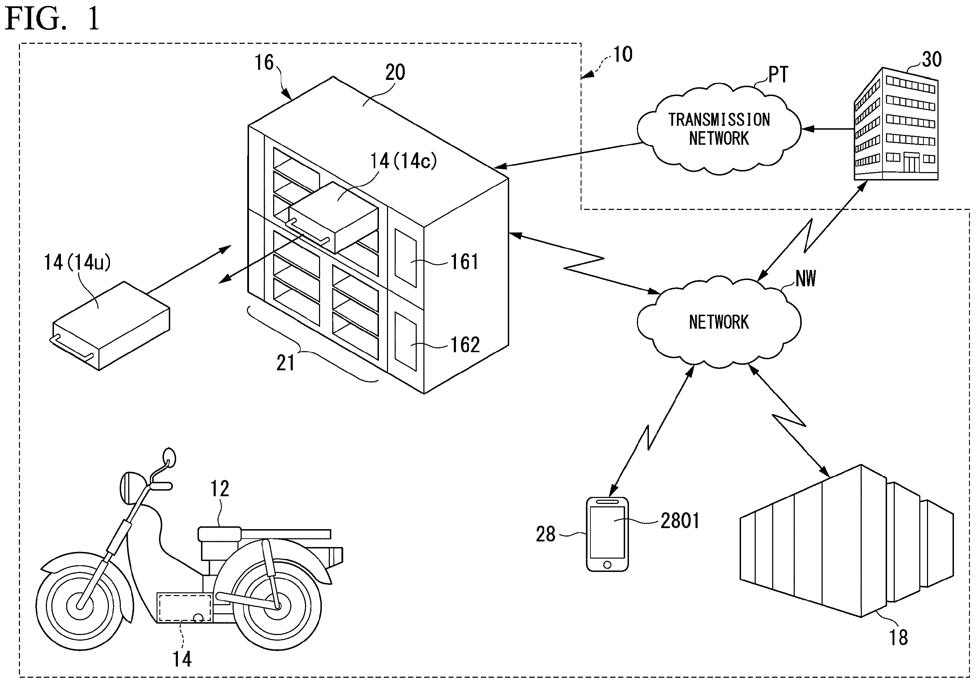

Fig. 1 is a view showing the entire configuration of a shared battery utilization service system (a battery sharing service system) 10 according to an embodiment.

As shown in Fig. 1, the shared battery utilization service system 10 is configured to include a moving body such as a saddle riding motorcycle 12 (a saddle riding vehicle, a moving body) or the like, a detachable battery 14 (a battery, a cell), a charging station (a charger) 16, a management server 18 (a server device), and a portable terminal 28.

The moving body includes a vehicle other than the motorcycle 12 (an electric saddle riding vehicle) shown in Fig. 1. An example of the moving body that is not a vehicle is, for example, a portable charge feeding device carried by a person or a vehicle disclosed in Japanese Unexamined Patent Application, First Publication No. 2019-068552.

In addition, the moving body may be a mobile robot, an autonomous traveling device, an electric bicycle, an autonomous traveling vehicle, another electrically driven vehicle, a drone flying object, or another electric moving device (electric mobility).

Hereinafter, the embodiment in which the motorcycle 12 is used as the example of the moving body will be described below.

The shared battery utilization service system 10 is a system configured to provide a sharing service in which the detachable battery 14 that is a driving source of the motorcycle 12 is shared by a plurality of users. The motorcycle 12 is an electric vehicle (EV) driven by electric power supplied from the detachable battery 14.

An electric power company 30 supplies electric power to the charging station 16 via a transmission network PT. The electric power company 30 transmits an amount of power consumed to the management server 18 via, for example, a network NW.

The detachable battery 14 is a cassette type electrical storage device detachably mounted on the motorcycle 12 that can be driven by at least electric power. The detachable battery 14 stores battery usage state information. The battery usage state information may also be referred to as information related to power consumption rate, and the battery usage state information includes an amount of power used from the start of the rental until the return of the detachable battery 14, traveling distance information of the motorcycle 12 from the start of the rental until the return of the detachable battery 14, and identification information (battery identification information, also referred to as a battery ID) of the detachable battery 14. Further, the battery usage state information or the information related to the power consumption rate may be constituted by the amount of power used from the start of the rental until the return of the detachable battery 14 and the traveling distance information of the motorcycle 12 from the start of the rental until the return of the detachable battery 14 (i.e., a traveling distance of the moving body).

Hereinafter, for the convenience of description, the detachable battery 14 that requires charging may be distinguished as "a used battery 14u" and the detachable battery 14 that has completed charge may be distinguished as "a charged battery 14c." Further, at least one detachable battery 14 is mounted on one motorcycle 12. The configuration of the detachable battery 14 will be described below. Further, in the embodiment, it is assumed that the type of the detachable battery 14 used in the shared battery utilization service system 10 is one type.

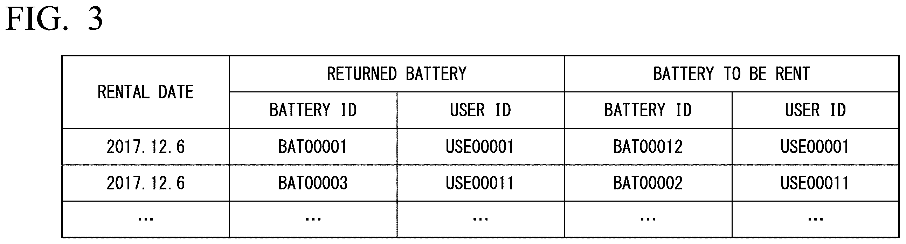

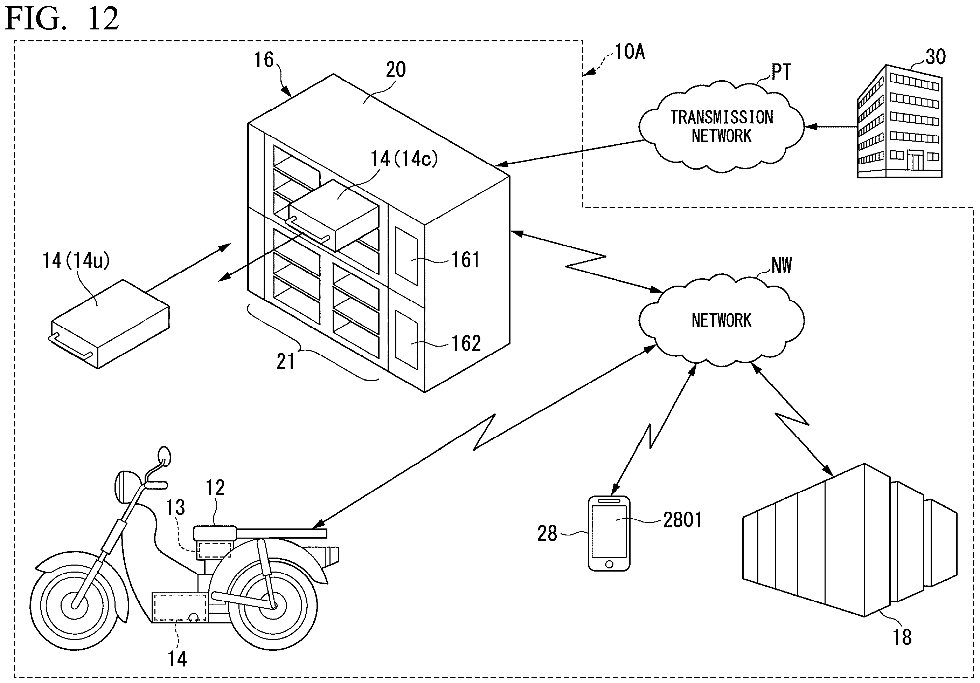

The charging stations 16 are facilities that perform storage and charge of one or more the detachable batteries 14, and are installed at a plurality of places. A slot section 21 constituted by a plurality of (in the example of Fig. 1, 12) slots, an indicator 161, and an authentication device 162 are provided in a housing 20 of the charging station 16. The charging station 16 is connected to the management server 18 to communicate therewith via the network NW. The network NW is a wireless communication network or a wired communication network. A charger 163 (Fig. 3) configured to charge the detachable battery 14 and a connecting section 164 (Fig. 3) are provided on a back side of the slot section 21. The charging station 16 acquires battery usage state information (information related to a power consumption rate) from the detachable battery 14 inserted into the slot section 21. The charging station 16 transmits the acquired battery usage state information to the management server 18. The charging station 16 transmits the number of the used batteries 14u and the number of the charged batteries 14c to the management server 18.

The management server 18 acquires the number of the used batteries 14u and the number of the charged batteries 14c transmitted from the charging station 16, and manages the detachable batteries 14 stored in the charging station 16 on the basis of the acquired information. The management server 18 performs reservation processing of renting the detachable battery 14 on the basis of, for example, the result obtained by operating the portable terminal 28 by a user. The management server 18 transmits the reservation result to the portable terminal 28. The management server 18 performs billing according to a situation in which a user uses the detachable battery 14. Further, a billing method may be an annual contract, a monthly contract, an n-times contract, or a one-time contract. The management server 18 is connected to the charging station 16 and the portable terminal 28 to communicate therewith via the network NW.

The management server 18 calculates points (a return amount, a privilege) of each user on the basis of battery usage state information (information related to a power consumption rate) received from the charging station 16. The management server 18 transmits point information related to the calculated points to, for example, the portable terminal 28. Further, a method of calculating points will be described below.

The portable terminal 28 is a terminal carried by a user, for example, a smartphone, a tablet terminal, a laptop computer, or the like. The portable terminal 28 includes a display unit 2801. A user operates the portable terminal 28, selects one of the charging stations 16 where the detachable battery 14 can be rented, and reserves the charging station 16. The portable terminal 28 transmits the operation results to the management server 18. The portable terminal 28 receives the points information transmitted from the management server 18, and displays the received points information on the display unit 2801.

### [Relationship between detachable battery 14 and user ID]

Next, a relationship between the detachable battery 14 in the shared battery utilization service system 10 and identification information (user identification information, a user ID) of a user will be described.

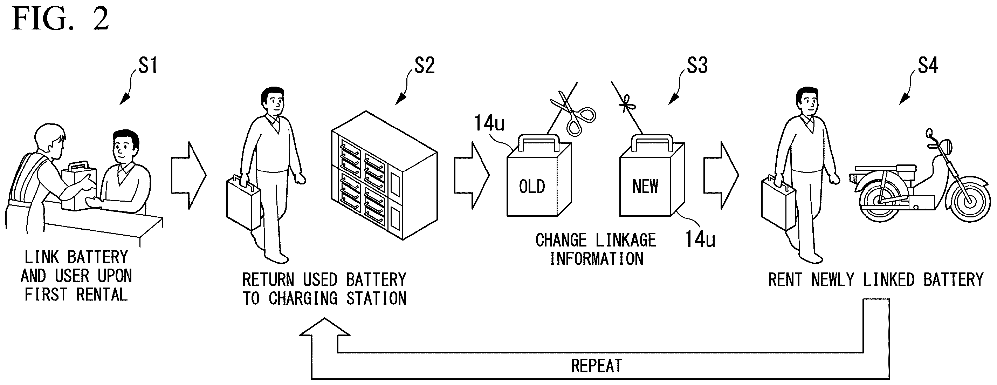

Fig. 2 is a view showing transfer of a relationship between a battery ID and a user ID according to the embodiment.

(Step S1) A user visits a battery supply shop or the charging station 16 when starting the use of the system. The user registers user information upon starting rental of a first battery. The user information includes the user's full name, the user's address, information on the motorcycle 12 the user is riding, information on where the usage fee will be withdrawn, and the like. Next, the battery supply shop or the charging station 16 transmits the acquired user information to the management server 18. Next, the management server 18 stores the acquired user information. Next, the management server 18 generates a user ID on the basis of the user information, and transmits the generated user ID to the charging station 16. Next, the battery supply shop or the charging station 16 links the user ID to the battery ID of the detachable battery 14 that is rented, and transmits the linked information to the management server 18. Further, the management server 18 stores the battery ID.

Further, the user ID may be generated by the battery supply shop or the charging station 16, and in this case, the charging station 16 may link the generated user ID to the battery ID of the detachable battery 14 rented and may transmit it to the management server 18.

### (Step S2) The user visits the charging station 16 to return the used detachable battery 14 (the used battery 14u).

(Step S3) The charging station 16 reads the battery ID of the used battery 14u that was returned. Next, the charging station 16 transmits the battery ID of the used battery 14u and the battery ID of the charged battery 14c that can be rented to the management server 18. Next, the management server 18 performs transfer of linkage information by releasing linkage of the user ID linked to the battery ID of the used battery 14u that was returned, and linking the user ID to the battery ID of the charged battery 14c that is going to be rent on the basis of the information received from the charging station 16. Next, the management server 18 transmits the newly linked information to the charging station 16.

(Step S4) The charging station 16 rents the detachable battery 14 (the charged battery 14c) newly linked to the user ID after transfer of the linkage information has been terminated by the management server 18.

Fig. 3 is a view showing a relationship between the detachable battery 14 according to the embodiment and the user ID.

In the example shown in Fig. 3, on December 6, 2017, a battery with ID "BAT00001" was returned, and a user ID "USE00001" was linked to this detachable battery 14 upon return. The management server 18 releases this linkage, and relinks the user ID "USE00001" to the battery ID of "BAT00012" of the detachable battery 14 that is going to be rent.

### [Configuration of detachable battery 14]

Next, a configuration example of the detachable battery 14 will be described.

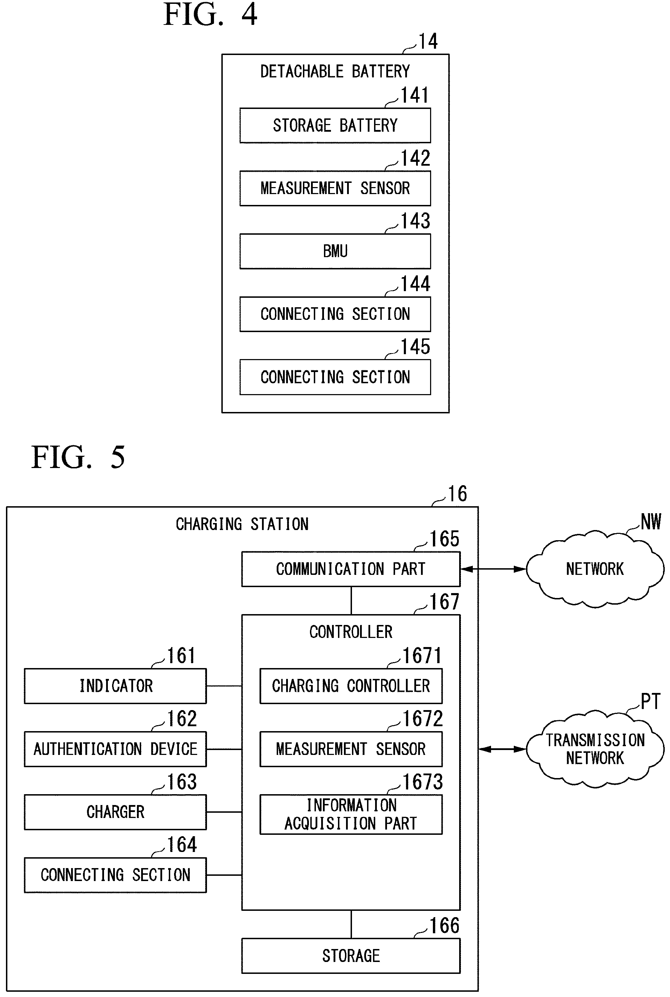

Fig. 4 is a view showing a configuration example of the detachable battery 14 according to the embodiment. As shown in Fig. 4, the detachable battery 14 includes a power storage 141, a measurement sensor 142, a BMU 143, a storage 144, and a connecting section 145.

The power storage 141 is for example, any one of a secondary battery, a lead storage battery, a capacitor, a lithium ion battery, and the like.

The measurement sensor 142 is constituted by various types of sensors configured to measure a current or a temperature. The measurement sensor 142 outputs the measured measurement value to the BMU 143. The temperature sensor measures a temperature of the power storage 141. In addition, the current sensor measures a value of the current that flows to the power storage 141.

The BMU 143 is a battery management unit, and controls charge or power feeding to the power storage 141. The BMU 143 stores the measurement value output from the measurement sensor 142 to the storage 144 at, for example, each predetermined timing. The BMU 143 calculates an amount of power used from the start of the rental until the return of the detachable battery 14 on the basis of a state of charge (SOC), a remaining capacity, and information of a current and a voltage upon discharge of the detachable battery 14 and stores the amount of power used that was calculated in the storage 144. The BMU 143 acquires the traveling distance information related to the traveling distance during the rental period from the start of the rental until the return of the detachable battery 14 from the motorcycle 12, and stores the acquired traveling distance information in the storage 144. The BMU 143 associates the amount of power used and the traveling distance information with the battery ID, and stores it in the storage 144. The BMU 143 outputs the information stored in the storage 144 to the charging station 16 when the detachable battery 14 is inserted into the slot section 21 of the charging station 16.

The storage 144 stores battery usage state information (information related to a power consumption rate). The storage 144 stores identification information of the detachable battery 14, a measurement value (including temperature information) of the measurement sensor 142 during the rental period, information of the SOC of the detachable battery 14 during the rental period, and the like. The storage 144 stores a program of causing the BMU 143 to execute processing.

The connecting section 145 is a connecting section to the slot section 21 of the charging station 16, and has a communication function.

### [Configuration of charging station 16]

Next, a configuration example of the charging station 16 will be described.

Fig. 5 is a view showing the configuration example of the charging station 16 according to the embodiment. As shown in Fig. 5, the charging station 16 includes the indicator 161, the authentication device 162, the charger 163, the connecting section 164, a communication part 165, a storage 166, and a controller 167.

The controller 167 includes a charge controller 1671, a measurement sensor 1672, and an information acquisition part 1673.

Further, the charging station 16 receives electric power from the transmission network PT.

The indicator 161 is any one of a liquid crystal display device, an organic electro luminescence (EL) display device, an electronic ink display device, and the like. The indicator 161 displays the information output from the controller 167. The displayed information is, for example, a remaining capacity, a usage fee, or the like, of the detachable battery 14.

The authentication device 162 is an instrument configured to read recording information of a near field communication (NFC) card (not shown) carried by a user using, for example, NFC. Accordingly, the charging station 16 reads the user ID included in the recording information. The authentication device 162 outputs the acquired user ID to the controller 167, and authenticates a user having usage authority of a sharing service on the basis of the authentication result output from the communication part 165.

The charger 163 is an instrument configured to charge the detachable battery 14 under control of the controller 167 in a state in which the connecting section 145 of the detachable battery 14 is connected to the connecting section 164 of the charging station 16. A power supply (not shown) configured to supply electric power to the detachable battery 14 is connected to the charger 163.

The connecting section 164 is a connecting section to the detachable battery 14, and performs supply of electric power and transmission and reception of information. The connecting section 164 acquires battery usage state information (information related to a power consumption rate) output from the detachable battery 14, and outputs the acquired battery usage state information to the information acquisition part 1673.

The communication part 165 transmits the battery usage state information (the information related to the power consumption rate) output from the controller 167 to the management server 18 via the network NW. The communication part 165 receives reservation information of the detachable battery 14 transmitted from the management server 18, and outputs the received reservation information of the detachable battery 14 to the controller 167. The communication part 165 transmits the number of rentable detachable batteries 14 which are assigned at the charging station 16, which is output from the controller 167, or the like, to the management server 18. The communication part 165 transmits the user ID to which the identification information of the charging station 16 is assigned, which is output from the controller 167, to the management server 18. The communication part 165 receives the authentication result authenticated by the management server 18, and outputs the received authentication result to the authentication device 162.

The storage 166 stores identification information of the charging station 16, and stores the battery usage state information (the information related to the power consumption rate) or the like when the detachable battery 14 is returned. The storage 166 stores a program causing the controller 167 to execute processing.

The controller 167 acquires the battery usage state information (the information related to the power consumption rate) output from the connecting section 164, and outputs the acquired battery usage state information to the communication part 165. Further, the battery ID is assigned to the battery usage state information. As described above, the user ID is linked to the battery ID. Further, the controller 167 may cause the storage 166 to store the battery usage state information (the information related to the power consumption rate).

Further, the controller 167 functions as the charge controller 1671, the information acquisition part 1673, and a processing part 1674 by reading and executing a program stored in the storage 166. The controller 167 detects the number of rentable detachable batteries 14 on the basis of the information stored in the storage 166, and the charging station 16 outputs the assigned number of the rentable detachable batteries 14 that were detected to the communication part 165.

The controller 167 allows rental of the detachable battery 14 to the user when authentication of the user by the authentication device 162 is successful.

The charge controller 1671 controls the charger 163 such that charging of the detachable battery 14 inserted into the slot section 21 is performed on the basis of the measurement value of the measurement sensor 1672.

The measurement sensor 1672 is, for example, a current sensor and a voltage sensor. The measurement sensor 1672 measures values of the current and the voltage that flow to the detachable battery 14, and outputs the measurement values to the charge controller 1671.

The information acquisition part 1673 acquires the battery information output from the detachable battery 14 connected to the connecting section 164, and stores the acquired battery information in the storage 166.

### [Configuration of management server 18]

Next, a configuration example of the management server 18 will be described.

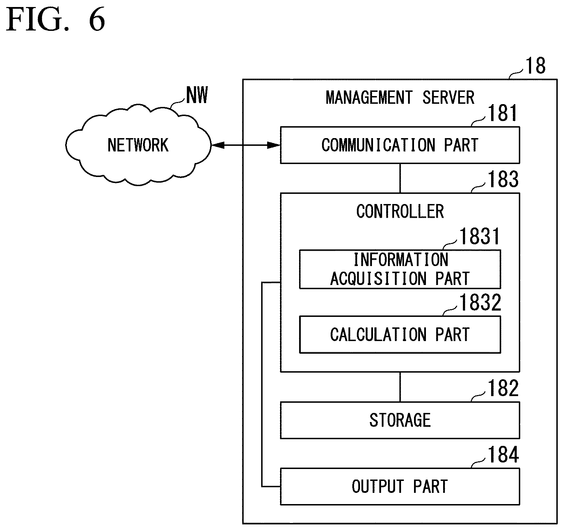

Fig. 6 is a view showing the configuration example of the management server 18 according to the embodiment. As shown in Fig. 6, the management server 18 includes a communication part 181, a storage 182, a controller 183, and an output part 184. In addition, the controller 183 includes an information acquisition part 1831, and a calculation part 1832.

The communication part 181 receives the battery usage state information (the information related to the power consumption rate) transmitted from the charging station 16 via the network NW, and outputs the received battery usage state information to the controller 183. The communication part 181 transmits the information related to the points (the privilege) output from the controller 183 to the portable terminal 28 via the network NW.

During the rental period, the storage 182 associates the battery ID (battery identification information) with either one of the user or the user ID (user identification information) and stores it as corresponding information.

The storage 182 stores an amount of power used and traveling distance information of each user and upon each rental use. The storage 182 stores the program causing the controller 183 to execute processing.

The controller 183 acquires the battery usage state information (the information related to the power consumption rate) output from the communication part 181, and stores the acquired battery usage state information in the storage 182. The controller 183 calculates a power consumption rate for each user and upon each rental use. The controller 183 calculates an average value of the power consumption rates of the users in the predetermined period. The controller 183 calculates the points (the privilege) of each user on the basis of the calculated power consumption rate of each user. The predetermined period is, for example, one week.

Further, in the embodiment, the power consumption rate will be stated using units of [km/kwh]. However, the power consumption rate is an indicator representing a traveling distance per unit capacity of an electric power energy source (various types of power supplies, batteries, or the like) or how much electric power is required for traveling a certain distance, and any unit other than [km/kwh] may be used as long as it satisfies this indicator.

The information acquisition part 1831 acquires the battery usage state information (the information related to the power consumption rate) output from the communication part 181, and outputs the acquired battery usage state information to the calculation part 1832.

The calculation part 1832 calculates the power consumption rate when the detachable battery 14 is returned, and associates the calculated power consumption rate with the user ID linked to the battery ID and stores it in the storage 182.

The calculation part 1832 specifies a user of the returned detachable battery 14 on the basis of the battery ID (battery identification information) and the corresponding information stored in the storage 182.

The calculation part 1832 calculates, for example, an improvement result in the power consumption rate for each user on the basis of the power consumption rate of the plurality of users and calculates the points (the privilege) for each user on the basis of the calculated result.

In addition, the calculation part 1832 may calculate, for example, an average value of the power consumption rates of each of the users at each of arbitrary timings, and calculate the points (the privilege) for each user on the basis of the calculated result. Further, a method of calculating points will be described below. The arbitrary timing is, for example, every week or every month.

The output part 184 is an image display device, a printing device, or the like. The output part 184 displays or prints the points for each user output from the controller 183.

### [Method of calculating points]

Next, a method of calculating points will be described.

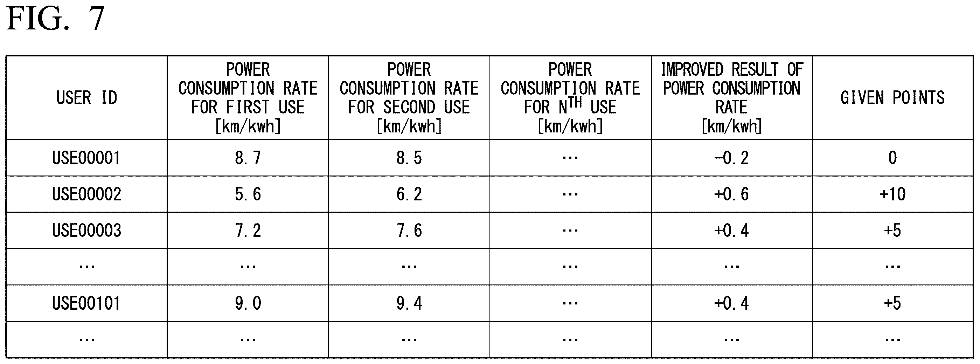

Fig. 7 is a view showing an example of a power consumption rate for each user, and an improvement result for the power consumption rate and assigned points according to the embodiment.

When the detachable battery 14 is returned, the calculation part 1832 of the management server 18 calculates a power consumption rate [km/kwh] from the start of the rental until the return for each user and upon each rental use on the basis of the information acquired from the charging station 16. The calculation part 1832 associates the power consumption rate calculated as shown in Fig. 7 with the user ID and stores it in the storage 182. In the example shown in Fig. 7, the storage 182 stores the user ID "USE00001" while being associated with the power consumption rates of "8.7 [km/kwh]" and "8.5 [km/kwh]" ..., and so on.

Specifically, the information acquisition part 1831 acquires the amount of power used and the traveling distance information of the returned detachable battery 14 (the battery ID of "BAT00001") for each user. The calculation part 1832 calculates the first usage power consumption rate of "8.7 [km/kwh]" by using the obtained amount of power used and the obtained traveling distance information.

The calculation part 1832 reads the user ID "USE00001", which is linked to the battery ID "BAT00001" of the returned detachable battery 14, from the storage 182. The calculation part 1832 associates the power consumption rate of "8.7 [km/kwh]" with the user ID "USE00001" and stores it in the storage 182.

The information acquisition part 1831 acquires the amount of power used and the traveling distance information of the returned detachable battery 14 (the battery ID of "BAToo011"). The calculation part 1832 calculates the second usage power consumption rate of "8.5 [km/kwh]" by using the obtained amount of power used and the obtained traveling distance information.

The calculation part 1832 reads the user ID "USE00001", which is linked to the battery ID "BAT00001" of the returned detachable battery 14, from the storage 182. The calculation part 1832 associates the power consumption rate of "8.5 [km/kwh]" with the user ID "USE00001" and stores it in the storage 182.

The calculation part 1832 calculates the result which is an improvement in the power consumption rate for each user on the basis of the power consumption rate of the user acquired by the information acquisition part 1831. For example, in the example shown in Fig. 7, the calculation part 1832 compares the first usage power consumption rate of "9.0 [km/kwh]" with the second usage power consumption rate of "9.4 [km/kwh]" of the user ID "USE00101", and calculates the improvement result of the power consumption rate. In the example of Fig. 7, the calculation part 1832 calculates that the power consumption rate of the user ID "USE00101" was improved by "+0.4 [km/kwh]" in the second usage in comparison with the first usage.

The calculation part 1832 calculates the privilege provided to each user on the basis of the improvement result of the power consumption rate calculated for each user. For example, in the example shown in Fig. 7, the calculation part 1832 calculates the privilege provided to each user as provided points on the basis of the improvement result of the power consumption rate calculated for each user. Specifically, a large number of points (a privilege) is provided to a user whose power consumption rate is improved in comparison with the previous usage. For example, the calculation part 1832 calculates the provided points as 0 points with respect to the user ID "USE00001" for which there was no improvement in the power consumption rate in the second usage in comparison with the first usage. In addition, for example, the calculation part 1832 calculates the provided points as 5 points with respect to the user ID "USE00003" and "USE00101" for which the power consumption rate has improved by "+0.4 [km/kwh]" in the second usage in comparison with the first usage. In addition, for example, the calculation part 1832 calculates the provide points as 10 points with respect to the user ID "USE00002" for which the power consumption rate has improved by "+0.6 [km/kwh]" in the second usage in comparison with the first usage.

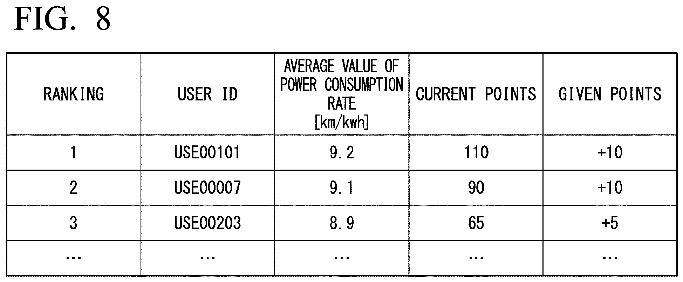

Fig. 8 is a view showing another example of assigned points according to the embodiment.

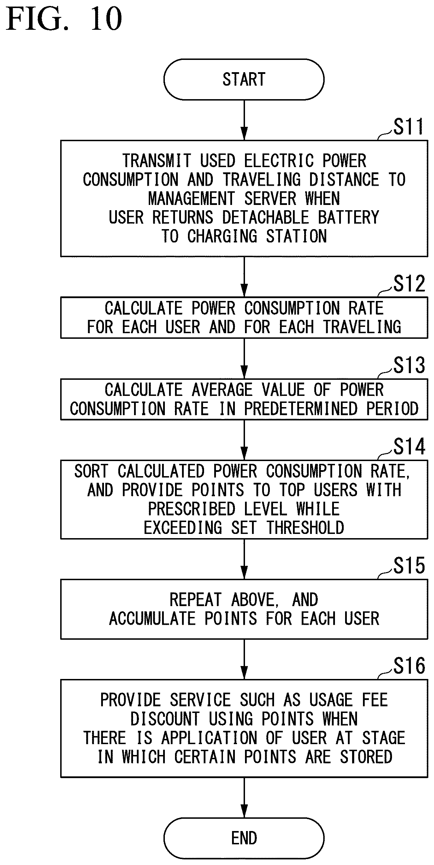

The calculation part 1832 obtains an average value of the power consumption rate for each user, for example, once per week. Then, the calculation part 1832 sorts the data in descending order of the power consumption rate as shown in Fig. 8. The calculation part 1832 provides points to each of predetermined higher-ranking users in the sorted data. In the example shown in Fig. 8, 10 points are assigned to a user whose average value of the power consumption rate is 9.0 [km/kwh] or more, and 5 points are assigned to a user whose average value is 8.0 [km/kwh] or more. Further, the calculation part 1832 may assign the same number of points to all of a predetermined number of people from the top.

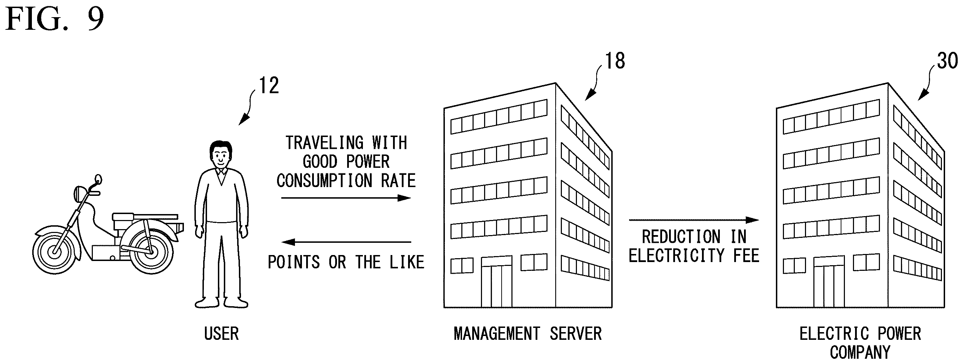

Fig. 9 is a view showing an example of returning points based on electricity bill reduction according to the embodiment.

It is assumed that the user who uses the motorcycle 12 makes a contract with a provider of this service on a monthly basis, for example, and pays a fee. Since the number of charges is smaller when driving with a good power consumption rate is performed compared to when driving with a poor power consumption rate is performed, the electric power used for the battery charge can be reduced. An electricity bill to be paid to the electric power company 30 can also be reduced by reducing the electric power required for battery charging in this way.

The management server 18 calculates the points that can be returned (applied) to the user on the basis of the costs that can be reduced in this way. In addition, the management server 18 may also calculate how many top users should be assigned points. For this reason, it can be made that the number of people to whom points can be assigned becomes larger as the electricity bills are further reduced. Alternatively, it can be made that the number of people to whom points are assigned is fixed, and the further electricity bills can be reduced, the more points may be assigned. Further, the management server 18 may provide a threshold such that the points are assigned to a predetermined number of people from the top who have a power consumption rate that is equal to or greater than the threshold.

### [Processing sequence of shared battery utilization service system 10]

Next, an example of a processing sequence performed by the shared battery utilization service system 10 will be described.

Fig. 10 is a flowchart of processing performed by the shared battery utilization service system 10 according to the embodiment. Further, in the processing shown in Fig. 9, the processing will be performed after each of the plurality of users have already performed registration of the user upon the first rental.

(Step S11) The controller 167 of the charging station 16 reads the battery usage state information (the information related to the power consumption rate) from the storage 144 of the detachable battery 14 when the user returns the detachable battery 14. Next, the controller 167 transmits the read battery usage state information to the management server 18 through the communication part 165.

(Step S12) The calculation part 1832 of the management server 18 calculates the power consumption rate for each user and upon each traveling using the received battery usage state information (the information related to the power consumption rate), and stores the calculated result in the storage 182. Further, the management server 18 retrieves the user ID by referring to the information stored in the storage 182 and the battery ID included in the received battery usage state information, and identifies the user of the returned detachable battery 14.

(Step S13) The calculation part 1832 calculates the average value of the power consumption rate for each user in the predetermined period, and stores the calculated average value of the power consumption rates for each user in the storage 182. Further, as described above, the calculation part 1832 may calculate the improvement result in the power consumption rate for each user on the basis of the power consumption rates of the plurality of users and store the improvement result of the calculated power consumption rate in the storage 182.

(Step S14) The calculation part 1832 rearranges (also referred to as sorts) the calculated average values of the power consumption rates in descending order at an arbitrary timing. Next, as a result of sorting, the calculation part 1832 assigns points to the top users in the specified ratio. In addition, the points may be assigned on the basis of the improvement result of the power consumption rate of the user. In this case, for example, a larger number of points (a privilege) may be assigned to a user whose power consumption rate has been improved (ameliorated) in comparison with the previous use.

(Step S15) The calculation part 1832 repeats processing of step S11 to S14, accumulates the points for each user, and updates the information stored in the storage 182.

(Step S16) The calculation part 1832 provides services such as usage fee discounts using the points when a user makes an application in a step in which a certain number of points has been accumulated.

The certain number of points is, for example, 100 points. The controller 183 of the management server 18 notifies the portable terminal 28 of the points, for example, monthly. The user checks the points displayed on the display unit 2801 of the portable terminal 28, and, for example, selects use of 100 points.

Further, while the example in which the battery ID is assigned to the battery usage state information (the information related to the power consumption rate) has been described in the above-mentioned example, there is no limitation thereto. Upon rental of the detachable battery 14, the controller 167 of the charging station 16 may store the user ID of the user who rents the detachable battery 14 in the storage 144 thereof. Alternatively, the controller 167 of the charging station 16 may assign the user ID acquired by the authentication device 162 to the battery usage state information when the detachable battery 14 is returned. In these cases, the controller 167 of the charging station 16 may transmit the battery usage state information including the user ID to the management server 18 through the communication part 165.

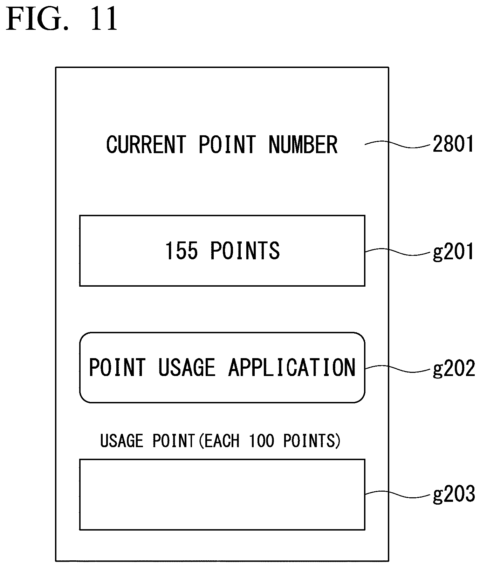

Fig. 11 is a view showing an image example displayed on the display unit 2801 of the portable terminal 28 according to the embodiment. In Fig. 11, reference sign g201 designates an image showing the number of current points. Reference sign g202 designates a button image for point usage application. Reference sign g203 designates an image of a field in which the points to be used are input when the points are used.

Further, the image shown in Fig. 11 is an example, and there is no limitation thereto.

In addition, the controller 183 of the management server 18 may transmit the image data shown in Fig. 11 to the charging station 16 when the detachable battery 14 is returned. In this case, the controller 183 may display the image shown in Fig. 11 on the indicator 161.

As described above, in the embodiment, from the start of the rental until the return of the detachable battery 14 at the charging station 16 by a user is set as one cycle, and the power consumption rate for each cycle is measured from the usage charge/discharge quantity and the moving distance on the basis of the information received from the charging station 16 by the management server 18. Then, in the embodiment, a service of providing a privilege such as point assignment to a user with a good power consumption rate and discounting the fee or the like by the accumulated points is provided.

According to the configuration, since the user can receive return such as points or the like by improving the power consumption rate according to the embodiment, motivation of the user for improving the power consumption rate can be improved. Accordingly, according to the embodiment, it is possible to contribute to reduction in carbon dioxide (reduction in power consumption due to improvement of a power consumption rate) even in EV usage environment of the user.

### <Second embodiment>

While the example in which the charging station 16 transmits the amount of power used and the traveling distance information (the information related to the power consumption rate) acquired from the detachable battery 14 to the management server 18 has been described in the first embodiment, there is no limitation thereto. In the embodiment, an example in which a communication device is mounted on the motorcycle 12 and the communication device transmits the amount of power used and the traveling distance information (the information related to the power consumption rate) to the management server 18 will be described.

### [Entire configuration]

Fig. 12 is a view showing the entire configuration of a shared battery utilization service system 10A according to the embodiment.

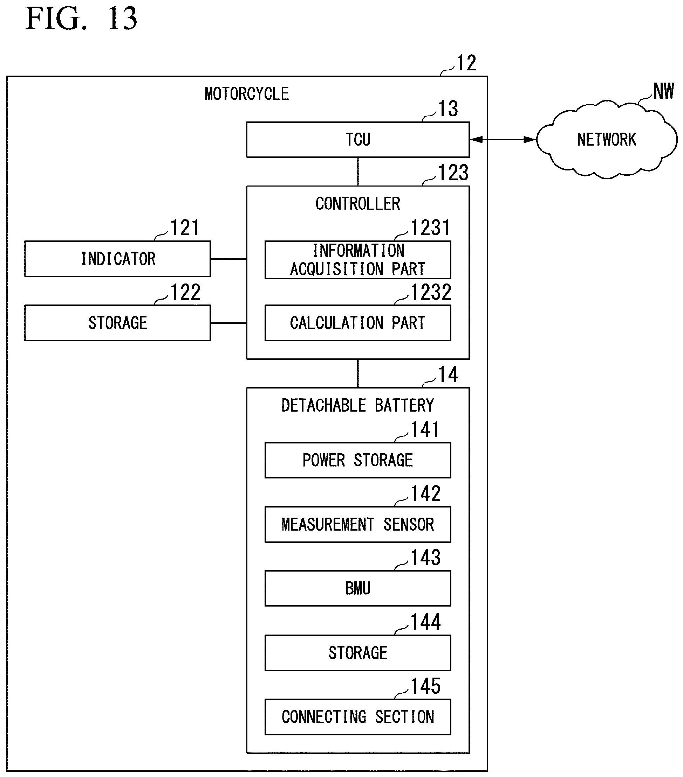

As shown in Fig. 12, the shared battery utilization service system 10A is configured to include a saddle riding motorcycle 12 (a saddle riding vehicle, a moving body), a TCU 13, a detachable battery 14 (a battery, a cell), a charging station (a charger) 16, a management server 18 (a server device), and a portable terminal 28. Components having the same functions as those of the shared battery utilization service system 10 are designated by the same reference signs and description thereof will be omitted. The TCU 13 will be described using Fig. 13.

### [Configuration of motorcycle 12]

Fig. 13 is a view showing a configuration example of the motorcycle 12 according to the embodiment. As shown in Fig. 13, the motorcycle (the moving body) 12 includes the TCU 13, an indicator 121, a storage 122, a controller 123, and the detachable battery 14. The controller 123 includes an information acquisition part 1231, and a calculation part 1232.

The indicator 121 is configured to include a speed meter, an odometer, a turning indication display lamp, a shift lever position display lamp, a battery residual capacity meter, and the like. The indicator 121 displays information output from the controller 123.

The storage 122 stores a traveling distance from the beginning of rental of the detachable battery 14 (the information related to the power consumption rate). The storage 122 stores a program of causing the controller 123 to execute processing.

The controller 123 generates various types of information displayed on the indicator 121 on the basis of the information acquired from the detachable battery 14 and the motorcycle 12, and outputs the generated information to the indicator 121.

The information acquisition part 1231 acquires the traveling distance from the motorcycle 12, and outputs the acquired traveling distance to the calculation part 1232. The information acquisition part 1231 acquires the amount of power used (the information related to the power consumption rate) and the battery ID from the storage 144 of the detachable battery 14, and outputs the amount of power used and the battery ID that were acquired to the TCU 13. The information acquisition part 1231 acquires the traveling distance information from the storage 122, and outputs the acquired traveling distance information to the TCU 13.

The calculation part 1232 acquires the traveling distance output from the information acquisition part 1231, and calculates the traveling distance from the beginning of rental. The calculation part 1232 stores the calculated traveling distance from the beginning of rental in the storage 122.

The telematics communication part (TCU) 13 is a communication part mounted in the motorcycle 12. The TCU 13 acquires the amount of power used, the battery ID, and the traveling distance information output from the information acquisition part 1231. The TCU 13 transmits the amount of power used and the traveling distance information to which the battery ID is assigned to the management server 18 via the network NW. The transmission timing is, for example, a predetermined time point or a predetermined time interval (for example, every minute).

Further, the motorcycle 12 may include a global positioning system (GPS) receiver (not shown). When the motorcycle 12 includes the GPS receiver, the TCU 13 may acquire position information (a latitude, a longitude) from the GPS receiver, and may transmit the acquired position information to the management server 18 together with the amount of power used and the traveling distance information to which the battery ID is assigned.

Even in the embodiment, the management server 18 calculates the power consumption rate for each user on the basis of the amount of power used and the traveling distance information (the information related to the power consumption rate) to which the acquired battery ID is assigned. Then, the management server 18 assigns the points to each user.

As described above, in the embodiment, from the start of the rental until the return of the detachable battery 14 at the charging station 16 by a user is set as 1 cycle, and the power consumption rate for each cycle is measured from the usage charge/discharge quantity and the moving distance by the management server 18. Then, even in the embodiment, like the first embodiment, a service of assigning the privilege such as point assignment or the like to a user with a good power consumption rate and performing discount or the like of the fee according to the accumulated points is provided.

According to the configuration, even in the embodiment, the same effects as those of the first embodiment can be obtained.

Further, while the example in which the points are returned as a return amount to users with higher power consumption rates has been described in the above-mentioned first and second embodiments, there is no limitation thereto. The return amount may be a discount amount from the usage fee or may be the number of free usages, a free usage period, or the like.

Further, while the example in which notification is transmitted to the users only with higher power consumption rates has been described in the above-mentioned first and second embodiments, there is no limitation thereto. The management server 18 may transmit an advice for improving the power consumption rate to the portable terminal 28 of the user to which no point is assigned.

Further, a program configured to realize the functions of the management server 18 according to the present invention entirely or partially may be recorded on a computer-readable recording medium, and the processing performed by the management server 18 may be performed entirely or partially by reading and executing the program recorded on the recording medium using a computer system. Further, "the computer system" disclosed herein includes OS or hardware such as peripheral devices or the like. In addition, "the computer system" includes a WWW system including a homepage providing environment (or a display environment). In addition, "the computer-readable recording medium" is referred to as a storage device such as a flexible disk, an optomagnetic disk, a portable medium such as ROM, CD-ROM, or the like, a hard disk installed in a computer system, or the like. Further, "the computer-readable recording medium" may include a medium that holds a program for a certain time, for example, a volatile memory (RAM) in a computer system that is a server or a client when a program is transmitted via a network such as the Internet or the like or a communication line such as a telephone line or the like.

In addition, the program may be transmitted to another computer system from a computer system in which the program is stored in a storage device or the like via a transmission medium or by transmission waves in the transmission medium. Here, "the transmission medium" that transmits a program is referred to as a medium having a function of transmitting information, for example, a network (a communication network) such as the Internet or the like, a communication line (a communication wire) such as a telephone line or the like. In addition, the program may be configured to realize a part of the above-mentioned function. Further, the above-mentioned function may be a so-called differential file (a differential program) that can be assembled to and realized by the program already recorded in the computer system.

Hereinabove, while the aspects of performing the present invention have been described using the embodiments, the present invention is not particularly limited to the above-mentioned embodiment and various modifications and substitutions may be made without departing from the scope of the present invention.

### [Reference Signs List]

10, 10A...shared battery utilization service system, 12...motorcycle (moving body), 13...TCU, 14...detachable battery, 16...charging station (charger), 18...management server, 28...portable terminal, 141...power storage, 142...measurement sensor, 143...BMU, 144...storage, 145...connecting section, 161...indicator, 162...authentication device, 163...charger, 164...connecting section, 165...communication part, 166...storage, 167...controller, 1671...charge controller, 1672...measurement sensor, 1673...information acquisition part, 181...communication part, 182...storage, 183...controller, 184...output part, 1831...information acquisition part, 1832...calculation part, 121...indicator, 122...storage, 123...controller, 1231...information acquisition part, 1232...calculation part

## Claims

1. A server device (18) configured to provide a service in which batteries (14), which are detachably mounted on moving bodies (12) that are movable using electric power, are shared by a plurality of users, the server device (18) comprising:
an acquisition part (1831) configured to acquire, from at least one storage facility (16) or communication device (13), information related to a power consumption rate of each battery (14) when the battery (14) was used at a plurality of timings by a user of the plurality of users,
wherein the information related to the power consumption rate comprises an amount of the electric power used and a traveling distance of the moving body (12) during a rental period of the battery (14) and user identification information that is information that enables identification of a user of each battery (14), and
a storage (182), and
a controller (183) comprising a calculation part (1832) configured to calculate the power consumption rate, and associate the calculated power consumption rate with the user identification information based on the information, and store the calculated power consumption rate associated with the user identification information in the storage (182), and identify the user of the battery on the basis of the user identification information, and
calculate by a comparison of a change in the power consumption rate between (i) the calculated power consumption rate which was calculated at a first timing when the battery was used by the user and which is associated with the user identification information and (ii) the stored power consumption rate which was calculated at a second timing when the battery was used by the user and which is associated with the user identification information, for the previous rental period of a battery (14), that is stored in the storage (182) as an improvement result in the power consumption rate for the user of the plurality of users on the basis of each of the power consumption rates at the plurality of timings for the user of the plurality of users acquired by the acquisition part, and
calculate a privilege provided to the user based on the improvement result in the power consumption rate so that larger privilege is provided to a user who has improved more power consumption rate between the first timing and the second timing.

2. The server device (18) according to claim 1, further comprising a storage (182) configured to associate battery identification information that is information that enables identification of the battery (14) with either one of the user or user identification information that is information that enables identification of the user and stores the associated information as corresponding information during the rental period of the battery (14),
wherein the calculation part (1832) identifies the user of the battery (14) on the basis of the battery identification information and the corresponding information.

3. A shared battery utilization service system (10) configured to provide a service in which batteries (14), which are detachably mounted on moving bodies (12) that are movable using electric power, are shared by a plurality of users, the shared battery utilization service system (10) comprising:
batteries (14) configured to store information related to a power consumption rate of the battery (14) at a plurality of timings when used by a user of the plurality of users,
a storage facility (16) configured to charge the batteries (14) or a communication device (13) configured to acquire the information related to the power consumption rate from the batteries (14) and the storage facility (16), or the communication device (13), respectively, configured to transmit the information related to the power consumption rate acquired from the batteries (14) to a server device (18), and
a server device (18) according to claim 1 or 2 configured to calculate by a comparison of a change in the power consumption rate between (i) the calculated power consumption rate which was calculated at a first timing when the battery was used by the user and which is associated with the user identification information and (ii) the stored power consumption rate which was calculated at a second timing when the battery was used by the user and which is associated with the user identification information, for the previous rental period of a battery (14), that is stored in the storage (182) as an improvement result in the power consumption rate for the user of the plurality of users on the basis of each of the power consumption rates at the plurality of timings for the user of the plurality of users received from the storage device (16) or communication device (13), respectively, and further configured to calculate a privilege provided to the user based on the improvement result in the power consumption rate so that larger privilege is provided to a user who has improved more power consumption rate between the first timing and the second timing.

4. The shared battery utilization service system (10, 10A) according to claim 3, further comprising an information terminal (28) used by the user,
wherein the server device (18) transmits the improvement result in the power consumption rate to at least one of the storage device (16) configured to charge the battery (14) and the information terminal (28), and
the storage device (16) or the information terminal (28) displays the improvement result in the power consumption rate.

5. A method of providing a service in which batteries (14), which are detachably mounted on moving bodies (12) that are movable using electric power, are shared by a plurality of users, the method comprising:
acquiring, from at least one storage facility (16) or communication device (13), by an acquisition part (1831) information related to a power consumption rate of each battery (14) when the battery was used at a plurality of timings by a user of the plurality of users and user identification information that is information that enables identification of the user of the battery (14),
wherein the information related to the power consumption rate comprises an amount of the electric power used and a traveling distance of the moving body (12) during a rental period of each battery (14), and
calculating by a calculation part (1832) of a controller (183) the power consumption rate, and associating by the calculation part (1832) the calculated power consumption rate with the user identification information based on the information, and storing the calculated power consumption rate associated with the user identification information within a storage (182) by the calculation part (1832), and identifying by the calculation part (1328) the user of the battery on the basis of the user identification information, and
calculating by the calculation part (1832) by a comparison of a change in the power consumption rate between (i) the calculated power consumption rate which was calculated at a first timing when the battery was used by the user and which is associated with the user identification information and (ii) a power consumption rate which was calculated at a second timing when the battery was used by the user and which is associated with the user identification information, for the previous rental period of a battery (14), that is stored in the storage (182) as an improvement result in the power consumption rate for the user of the plurality of users on the basis of each of the power consumption rates at the plurality of timings for the user of the plurality of users, and
calculating a privilege provided to the user based on the improvement result in the power consumption rate so that larger privilege is provided to a user who has improved more power consumption rate between the first timing and the second timing.

6. A computer program configured to provide a service in which batteries (14), which are detachably mounted on moving bodies (12) that are movable using electric power, are shared by a plurality of users, the computer program configured to cause a computer to execute:
processing of acquiring, from at least one storage facility (16) or communication device (13), information related to a power consumption rate of each battery (14) when the battery was used at a plurality of timings by a user of the plurality of users,
wherein the information related to the power consumption rate comprises an amount of the electric power used and a traveling distance of the moving body (12) during a rental period of each battery (14) and user identification information that is information that enables identification of a user of the battery (14), and
processing of calculating the power consumption rate based on the information, and associating the calculated power consumption rate with the user identification information based on the information, and storing the calculated power consumption rate associated with the user identification information, and identifying by the calculation part (1328) the user of the battery on the basis of the user identification information, and
processing of calculating by a comparison of a change in the power consumption rate between (i) the calculated power consumption rate which was calculated at a first timing when the battery was used by the user and which is associated with the user identification information and (ii) a power consumption rate which was calculated at a second timing when the battery was used by the user and which is associated with the user identification information, for the previous rental period of a battery (14), that is stored in the storage (182) as an improvement result in the power consumption rate for the user of the plurality of users on the basis of each of the power consumption rates at the plurality of timings for the user of the plurality of users, and calculating a privilege provided to the user based on the improvement result in the power consumption rate so that larger privilege is provided to a user who has improved more power consumption rate between the first timing and the second timing.

7. A computer-readable recording medium on which the computer program according to claim 6 is recorded.

## Patentansprüche

1. Eine Servervorrichtung (18), die so ausgebildet ist, dass sie einen Dienst bereitstellt, bei dem an mittels elektrischer Energie bewegbaren Körpern (12) angebrachte abnehmbare Batterien (14) von mehreren Benutzern gemeinsam genutzt werden, wobei die Servervorrichtung (18) aufweist:
einen Erfassungsteil (1831), der so ausgebildet ist, dass er von zumindest einer Speichervorrichtung (16) oder einer Kommunikationsvorrichtung (13) Information bezüglich einer Stromverbrauchsrate jeder Batterie (14) erfasst, wenn die Batterie (14) zu einer Mehrzahl an Zeitpunkten von einem der Mehrzahl an Benutzern verwendet wurde,
wobei die Information bezüglich der Stromverbrauchsrate die Menge der verbrauchten elektrischen Energie und die zurückgelegte Strecke des bewegten Körpers (12) während der Mietdauer der Batterie (14) sowie Benutzeridentifikationsinformation umfasst, d. h. Information, die die Identifizierung eines Benutzers jeder Batterie (14) ermöglicht, und
einen Speicher (182), und
eine Steuereinheit (183), die einen Berechnungsteil (1832) aufweist, der so ausgebildet ist, dass er die Stromverbrauchsrate berechnet, die berechnete Stromverbrauchsrate auf der Grundlage der Information mit der Benutzeridentifikationsinformation verknüpft, die mit der Benutzeridentifikationsinformation verknüpfte berechnete Stromverbrauchsrate im Speicher (182) speichert und den Benutzer der Batterie auf der Grundlage der Benutzeridentifikationsinformation identifiziert, und
durch einen Vergleich der Änderung der Stromverbrauchsrate zwischen (i) der berechneten Stromverbrauchsrate, die zu einem ersten Zeitpunkt bei der Nutzung der Batterie durch den Benutzer berechnet wurde und der Benutzeridentifikationsinformation zugeordnet ist, und (ii) der gespeicherten Stromverbrauchsrate, die zu einem zweiten Zeitpunkt bei der Nutzung der Batterie durch den Benutzer berechnet wurde und der Benutzeridentifikationsinformation zugeordnet ist, für den vorangegangenen Mietzeitraum einer Batterie (14), die im Speicher (182) als Ergebnis der Verbesserung der Stromverbrauchsrate für den Benutzer aus der Mehrzahl an Benutzern auf der Grundlage jeder der Stromverbrauchsraten zu den verschiedenen Zeitpunkten für den Benutzer aus der Mehrzahl an Benutzern gespeichert ist, die von dem Erfassungsteil erfasst wurden, berechnet, und
eine dem Benutzer gewährte Vergünstigung auf der Grundlage des Verbesserungsergebnisses der Stromverbrauchsrate berechnet, so dass einem Benutzer, der die Stromverbrauchsrate zwischen dem ersten Zeitpunkt und dem zweiten Zeitpunkt stärker verbessert hat, eine größere Vergünstigung gewährt wird.

2. Die Servervorrichtung (18) nach Anspruch 1, ferner aufweisend einen Speicher (182), der so ausgebildet ist, dass er Batterieidentifikationsinformation - also Information, die eine Identifizierung der Batterie (14) ermöglicht - entweder mit Benutzer- oder Benutzeridentifikationsinformation - also Information, die eine Identifizierung des Benutzers ermöglicht - verknüpft und die verknüpfte Information während der Mietdauer der Batterie (14) als entsprechende Information speichert,
wobei der Berechnungsteil (1832) den Benutzer der Batterie (14) auf der Grundlage der Batterieidentifikationsinformation und der entsprechenden Information identifiziert.

3. Ein System (10) für einen gemeinsamen Batterienutzungsdienst, das so ausgebildet ist, dass es einen Dienst bereitstellt, bei dem an mittels elektrischer Energie bewegbaren Körpern (12) angebrachte abnehmbare Batterien (14) von mehreren Benutzern gemeinsam genutzt werden, wobei das System (10) für einen gemeinsamen Batterienutzungsdienst aufweist:
Batterien (14), die so ausgebildet sind, dass sie Information bezüglich einer Stromverbrauchsrate der Batterie (14) zu einer Mehrzahl an Zeitpunkten speichern, wenn sie von einem der Mehrzahl an Benutzern verwendet werden,
eine Speichervorrichtung (16), die so ausgebildet ist, dass sie die Batterien (14) auflädt, oder eine Kommunikationsvorrichtung (13), die so ausgebildet ist, dass sie die Information bezüglich der Stromverbrauchsrate von den Batterien (14) und der Speichervorrichtung (16) erfasst, oder die Kommunikationsvorrichtung (13), die jeweils so ausgebildet ist, dass sie die von den Batterien (14) erfasste Information bezüglich der Stromverbrauchsrate an eine Servervorrichtung (18) überträgt, und
eine Servervorrichtung (18) gemäß Anspruch 1 oder 2, die so ausgebildet ist, dass sie durch einen Vergleich eine Änderung der Stromverbrauchsrate zwischen (i) der berechneten Stromverbrauchsrate, die zu einem ersten Zeitpunkt berechnet wurde, als die Batterie vom Benutzer verwendet wurde, und die mit der Benutzeridentifikationsinformation verknüpft ist, und (ii) der gespeicherten Stromverbrauchsrate, die zu einem zweiten Zeitpunkt berechnet wurde, als die Batterie vom Benutzer verwendet wurde, und die mit der Benutzeridentifikationsinformation verknüpft ist, für den vorangegangenen Mietzeitraum einer Batterie (14), die im Speicher (182) als Ergebnis einer Verbesserung der Stromverbrauchsrate für den jeweiligen Benutzer aus der Mehrzahl an Benutzern auf der Grundlage jeder der Stromverbrauchsraten zu den verschiedenen Zeitpunkten für den jeweiligen Benutzer aus der Mehrzahl an Benutzern gespeichert ist, die von der Speichervorrichtung (16) oder der Kommunikationsvorrichtung (13) empfangen wurden, berechnet, und ferner so ausgebildet ist, dass sie auf der Grundlage des Verbesserungsergebnisses der Stromverbrauchsrate eine dem Benutzer gewährte Vergünstigung berechnet, sodass einem Benutzer, der die Stromverbrauchsrate zwischen dem ersten Zeitpunkt und dem zweiten Zeitpunkt stärker verbessert hat, eine größere Vergünstigung gewährt wird.

4. Das System (10, 10A) für einen gemeinsamen Batterienutzungsdienst gemäß Anspruch 3, ferner aufweisend ein vom Benutzer genutztes Informationsendgerät (28),
wobei die Servervorrichtung (18) das Ergebnis der Verbesserung der Stromverbrauchsrate an die zum Laden der Batterie (14) ausgebildete Speichervorrichtung (16) und/oder das Informationsendgerät (28) überträgt, und
die Speichervorrichtung (16) oder das Informationsendgerät (28) das Ergebnis der Verbesserung der Stromverbrauchsrate anzeigt.

5. Ein Verfahren zur Bereitstellung eines Dienstes, bei dem an mittels elektrischer Energie bewegbaren Körpern (12) angebrachte abnehmbare Batterien (14) von mehreren Benutzern gemeinsam genutzt werden, wobei das Verfahren aufweist:
Erfassen, durch einen Erfassungsteil (1831) von zumindest einer Speichervorrichtung (16) oder einer Kommunikationsvorrichtung (13), von Information bezüglich einer Stromverbrauchsrate jeder Batterie (14), wenn die Batterie zu einer Mehrzahl an Zeitpunkten von einem der Mehrzahl an Benutzern verwendet wurde, sowie von Benutzeridentifikationsinformation, d. h. Information, die eine Identifizierung des Benutzers der Batterie (14) ermöglicht,
wobei die Information bezüglich der Stromverbrauchsrate eine Menge der verbrauchten elektrischen Energie und eine zurückgelegte Strecke des bewegten Körpers (12) während einer Mietdauer jeder Batterie (14) umfasst, und
Berechnen, durch einen Berechnungsteil (1832), der Stromverbrauchsrate einer Steuerung (183) und Zuordnen der berechneten Stromverbrauchsrate zu der Benutzeridentifikationsinformation durch den Berechnungsteil (1832) auf der Grundlage der Information sowie Speichern der der Benutzeridentifikationsinformation zugeordneten berechneten Stromverbrauchsrate in einem Speicher (182) durch den Berechnungsteil (1832), und Identifizieren des Benutzers der Batterie durch den Berechnungsteil (1328) auf der Grundlage der Benutzeridentifikationsinformation, und Berechnen, durch den Berechnungsteil (1832), durch einen Vergleich einer Änderung der Stromverbrauchsrate zwischen (i) der berechneten Stromverbrauchsrate, die zu einem ersten Zeitpunkt berechnet wurde, als die Batterie vom Benutzer verwendet wurde, und die mit der Benutzeridentifikationsinformation verknüpft ist, und (ii) einer Stromverbrauchsrate, die zu einem zweiten Zeitpunkt berechnet wurde, als die Batterie vom Benutzer verwendet wurde, und die mit der Benutzeridentifikationsinformation verknüpft ist, für den vorangegangenen Mietzeitraum einer Batterie (14), die im Speicher (182) als ein Verbesserungsergebnis der Stromverbrauchsrate für den einen der Mehrzahl an Benutzern auf der Grundlage jeder der Stromverbrauchsraten zu der Mehrzahl an Zeitpunkten für den einen der Mehrzahl an Benutzern gespeichert ist, und
Berechnen einer dem Benutzer gewährten Vergünstigung auf der Grundlage des Ergebnisses der Verbesserung der Stromverbrauchsrate, sodass einem Benutzer, der die Stromverbrauchsrate zwischen dem ersten und dem zweiten Zeitpunkt stärker verbessert hat, eine größere Vergünstigung gewährt wird.

6. Ein Computerprogramm, das so ausgebildet ist, dass es einen Dienst bereitstellt, bei dem an mittels elektrischer Energie bewegbaren Körpern (12) angebrachte abnehmbare Batterien (14) von mehreren Benutzern gemeinsam genutzt werden, wobei das Computerprogramm so ausgebildet ist, dass es einen Computer veranlasst, Folgendes auszuführen:
ein Verarbeiten zum Erfassen von Information aus zumindest einer Speichervorrichtung (16) oder einer Kommunikationsvorrichtung (13), die sich auf die Stromverbrauchsrate jeder Batterie (14) bezieht, wenn die Batterie zu mehreren Zeitpunkten von einem der Mehrzahl an Benutzern verwendet wurde,
wobei die Information bezüglich der Stromverbrauchsrate eine Menge der verbrauchten elektrischen Energie und eine zurückgelegte Strecke des bewegten Körpers (12) während einer Mietdauer jeder Batterie (14) sowie Benutzeridentifikationsinformation umfasst, bei der es sich um Information handelt, die die Identifizierung eines Benutzers der Batterie (14) ermöglicht, und
ein Verfahren zum Berechnen der Stromverbrauchsrate auf der Grundlage der Information und zum Verknüpfen der berechneten Stromverbrauchsrate mit der Benutzeridentifikationsinformation auf der Grundlage der Information sowie zum Speichern der mit der Benutzeridentifikationsinformation verknüpften berechneten Stromverbrauchsrate und zum Identifizieren des Benutzers der Batterie durch den Berechnungsteil (1328) auf der Grundlage der Benutzeridentifikationsinformation, und
ein Verfahren zum Berechnen durch Vergleich einer Änderung der Stromverbrauchsrate zwischen (i) der berechneten Stromverbrauchsrate, die zu einem ersten Zeitpunkt bei der Nutzung der Batterie durch den Benutzer ermittelt wurde und der Benutzeridentifikationsinformation zugeordnet ist, und (ii) einer Stromverbrauchsrate, die zu einem zweiten Zeitpunkt bei der Nutzung der Batterie durch den Benutzer ermittelt wurde und der Benutzeridentifikationsinformation zugeordnet ist, für den vorangegangenen Mietzeitraum einer Batterie (14), die im Speicher (182) als Ergebnis der Verbesserung der Stromverbrauchsrate für den einen der Mehrzahl an Benutzern auf der Grundlage jeder der Stromverbrauchsraten zu der Mehrzahl an Zeitpunkten für den einen der Mehrzahl an Benutzern gespeichert ist, und Berechnen einer dem Benutzer gewährten Vergünstigung auf der Grundlage des Ergebnisses der Verbesserung der Stromverbrauchsrate, so dass einem Benutzer, der die Stromverbrauchsrate zwischen dem ersten Zeitpunkt und dem zweiten Zeitpunkt stärker verbessert hat, eine größere Vergünstigung gewährt wird.

7. Ein computerlesbares Aufzeichnungsmedium, auf dem das Computerprogramm gemäß Anspruch 6 gespeichert ist.

## Revendications

1. Dispositif serveur (18) configuré pour assurer un service dans lequel des batteries (14), qui sont montées de manière détachable sur des corps mobiles (12) mus électriquement, sont partagées par une pluralité d'utilisateurs, le dispositif serveur (18) comprenant :
une partie d'acquisition (1831) configurée pour acquérir, à partir d'au moins une installation de stockage (16) ou d'un dispositif de communication (13), des informations relatives à un taux de consommation d'énergie de chaque batterie (14) lorsque la batterie (14) a été utilisée à une pluralité de moments par un utilisateur de la pluralité d'utilisateurs,
dans lequel les informations relatives au taux de consommation d'énergie comprennent une quantité de l'énergie électrique utilisée et une distance parcourue du corps mobile (12) pendant une période de location de la batterie (14) et des informations d'identification d'utilisateur qui sont des informations qui permettent d'identifier un utilisateur de chaque batterie (14), et
une mémoire (182), et
un dispositif de commande (183) comprenant une partie de calcul (1832) configurée pour calculer le taux de consommation d'énergie, et associer le taux de consommation d'énergie calculé aux informations d'identification d'utilisateur sur la base des informations, et stocker le taux de consommation d'énergie calculé associé aux informations d'identification d'utilisateur dans la mémoire (182), et identifier l'utilisateur de la batterie sur la base des informations d'identification d'utilisateur, et
calculer par comparaison d'une variation du taux de consommation électrique entre (i) le taux de consommation d'énergie calculé qui a été calculé à un premier moment lorsque la batterie a été utilisée par l'utilisateur et qui est associé aux informations d'identification d'utilisateur et (ii) le taux de consommation d'énergie stocké qui a été calculé à un deuxième moment lorsque la batterie a été utilisée par l'utilisateur et qui est associé aux informations d'identification d'utilisateur, pour la précédente période de location d'une batterie (14), qui est stockée dans la mémoire (182) en tant que résultat d'amélioration du taux de consommation d'énergie pour l'utilisateur de la pluralité d'utilisateurs sur la base de chacun des taux de consommation d'énergie à la pluralité de moments pour l'utilisateur de la pluralité d'utilisateurs acquis par la partie d'acquisition, et
calculer un privilège accordé à l'utilisateur sur la base du résultat d'amélioration du taux de consommation d'énergie de sorte qu'un plus grand privilège soit accordé à un utilisateur qui a davantage amélioré un taux de consommation d'énergie entre le premier moment et le deuxième moment.

2. Dispositif serveur (18) selon la revendication 1, comprenant en outre une mémoire (182) configurée pour associer des informations d'identification de batterie, qui sont des informations qui permettent l'identification de la batterie (14), avec l'un ou l'autre de l'utilisateur ou des informations d'identification d'utilisateur, qui sont des informations qui permettent l'identification de l'utilisateur et stocke les informations associées en tant qu'informations correspondantes pendant la période de location de la batterie (14),
dans lequel la partie de calcul (1832) identifie l'utilisateur de la batterie (14) sur la base des informations d'identification de batterie et des informations correspondantes.

3. Système de service d'utilisation de batteries partagées (10) configuré pour assurer un service dans lequel des batteries (14), qui sont montées de manière détachable sur des corps mobiles (12) mus électriquement, sont partagées par une pluralité d'utilisateurs, le système de service d'utilisation de batterie partagée (10) comprenant :
des batteries (14) configurées pour stocker des informations relatives à un taux de consommation d'énergie de la batterie (14) à une pluralité de moments lorsqu'elles sont utilisées par un utilisateur de la pluralité d'utilisateurs,
une installation de stockage (16) configurée pour charger les batteries (14) ou un dispositif de communication (13) configuré pour acquérir les informations relatives au taux de consommation d'énergie des batteries (14) et l'installation de stockage (16), ou le dispositif de communication (13), respectivement, étant configurés pour transmettre les informations relatives au taux de consommation d'énergie acquises auprès des batteries (14) à un dispositif serveur (18), et
un dispositif serveur (18) selon la revendication 1 ou 2, configuré pour calculer par comparaison une variation du taux de consommation d'énergie entre (i) le taux de consommation d'énergie calculé qui a été calculé à un premier moment lorsque la batterie a été utilisée par l'utilisateur et qui est associé aux informations d'identification d'utilisateur et (ii) le taux de consommation d'énergie stocké qui a été calculé à un deuxième moment lorsque la batterie a été utilisée par l'utilisateur et qui est associé aux informations d'identification d'utilisateur, pour la précédente période de location d'une batterie (14), qui est stockée dans la mémoire (182) en tant que résultat d'amélioration du taux de consommation d'énergie pour l'utilisateur de la pluralité d'utilisateurs sur la base de chacun des taux de consommation d'énergie à la pluralité de moments pour l'utilisateur de la pluralité d'utilisateurs reçus du dispositif de stockage (16) ou du dispositif de communication (13), respectivement, et configuré en outre pour calculer un privilège accordé à l'utilisateur sur la base du résultat d'amélioration du taux de consommation d'énergie de sorte qu'un plus grand privilège soit accordé à un utilisateur qui a davantage amélioré un taux de consommation d'énergie entre le premier moment et le deuxième moment.

4. Système de service d'utilisation de batteries partagées (10, 10A) selon la revendication 3, comprenant en outre un terminal d'information (28) utilisé par l'utilisateur,
dans lequel le dispositif serveur (18) transmet le résultat d'amélioration du taux de consommation d'énergie à au moins l'un parmi le dispositif de stockage (16) configuré pour charger la batterie (14) et le terminal d'information (28), et
le dispositif de stockage (16) ou le terminal d'information (28) affiche le résultat d'amélioration du taux de consommation d'énergie.

5. Procédé de fourniture d'un service dans lequel des batteries (14), qui sont montées de manière détachable sur des corps mobiles (12) mus électriquement, sont partagées par une pluralité d'utilisateurs, le procédé comprenant :
l'acquisition, à partir d'au moins une installation de stockage (16) ou d'un dispositif de communication (13), par une partie d'acquisition (1831) d'informations relatives à un taux de consommation d'énergie de chaque batterie (14) lorsque la batterie a été utilisée à une pluralité de moments par un utilisateur de la pluralité d'utilisateurs et d'informations d'identification d'utilisateur qui sont des informations qui permettent d'identifier l'utilisateur de la batterie (14),
dans lequel les informations relatives au taux de consommation d'énergie comprennent une quantité de l'énergie électrique utilisée et une distance parcourue du corps mobile (12) pendant une période de location de chaque batterie (14), et
le calcul, par une partie de calcul (1832) d'un dispositif de commande (183), du taux de consommation d'énergie, et l'association par la partie de calcul (1832) du taux de consommation d'énergie calculé avec les informations d'identification d'utilisateur sur la base des informations, et le stockage du taux de consommation d'énergie calculé associé aux informations d'identification d'utilisateur au sein d'une mémoire (182) par la partie de calcul (1832), et l'identification par la partie de calcul (1328) de l'utilisateur de la batterie sur la base des informations d'identification d'utilisateur, et
le calcul, par la partie de calcul (1832), par comparaison d'une variation du taux de consommation d'énergie entre (i) le taux de consommation d'énergie calculé qui a été calculé à un premier moment lorsque la batterie a été utilisée par l'utilisateur et qui est associé aux informations d'identification d'utilisateur et (ii) un taux de consommation d'énergie qui a été calculé à un deuxième moment lorsque la batterie a été utilisée par l'utilisateur et qui est associé aux informations d'identification d'utilisateur, pour la précédente période de location d'une batterie (14), qui est stockée dans la mémoire (182) en tant que résultat d'amélioration du taux de consommation d'énergie pour l'utilisateur de la pluralité d'utilisateurs sur la base de chacun des taux de consommation d'énergie à la pluralité de moments pour l'utilisateur de la pluralité d'utilisateurs, et
le calcul d'un privilège accordé à l'utilisateur sur la base du résultat d'amélioration du taux de consommation d'énergie de sorte qu'un plus grand privilège soit accordé à un utilisateur qui a davantage amélioré un taux de consommation d'énergie entre le premier moment et le deuxième moment.

6. Programme informatique configuré pour assurer un service dans lequel des batteries (14), qui sont montées de manière détachable sur des corps mobiles (12) mus électriquement, sont partagées par une pluralité d'utilisateurs, le programme informatique étant configuré pour amener un ordinateur à exécuter :
le traitement d'acquisition, à partir d'au moins une installation de stockage (16) ou d'un dispositif de communication (13), d'informations relatives à un taux de consommation d'énergie de chaque batterie (14) lorsque la batterie a été utilisée à une pluralité de moments par un utilisateur de la pluralité d'utilisateurs,
dans lequel les informations relatives au taux de consommation d'énergie comprennent une quantité de l'énergie électrique utilisée et une distance parcourue du corps mobile (12) pendant une période de location de chaque batterie (14) et des informations d'identification d'utilisateur qui sont des informations qui permettent d'identifier un utilisateur de la batterie (14), et
le traitement du calcul du taux de consommation d'énergie sur la base des informations, et de l'association du taux de consommation d'énergie calculé avec les informations d'identification d'utilisateur sur la base des informations, et du stockage du taux de consommation d'énergie calculé associé aux informations d'identification d'utilisateur, et de l'identification par la partie de calcul (1328) de l'utilisateur de la batterie sur la base des informations d'identification d'utilisateur, et
le traitement du calcul par comparaison d'une variation du taux de consommation d'énergie entre (i) le taux de consommation d'énergie calculé qui a été calculé à un premier moment lorsque la batterie a été utilisée par l'utilisateur et qui est associé aux informations d'identification d'utilisateur et (ii) un taux de consommation d'énergie qui a été calculé à un deuxième moment lorsque la batterie a été utilisée par l'utilisateur et qui est associé aux informations d'identification d'utilisateur, pour la précédente période de location d'une batterie (14), qui est stockée dans la mémoire (182) en tant que résultat d'amélioration du taux de consommation d'énergie pour l'utilisateur de la pluralité d'utilisateurs sur la base de chacun des taux de consommation d'énergie à la pluralité de moments pour l'utilisateur de la pluralité d'utilisateurs, et du calcul d'un privilège accordé à l'utilisateur sur la base du résultat d'amélioration du taux de consommation d'énergie de sorte qu'un plus grand privilège soit accordé à un utilisateur qui a davantage amélioré un taux de consommation d'énergie entre le premier moment et le deuxième moment.

7. Support d'enregistrement lisible par ordinateur sur lequel est enregistré le programme informatique selon la revendication 6.
